# EUROPÄISCHE PATENTSCHRIFT

(11) **EP 3 467 140 B1**
(45) Veröffentlichungstag und Bekanntmachung des Hinweises auf die Patenterteilung: **15.04.2026**
(21) Anmeldenummer: 17001644.8
(22) Anmeldetag: 06.10.2017
(51) Int. Cl.: C23C 14/08, C23C 14/34, C04B 35/495, C04B 35/645

(54) **TARGETMATERIAL ZUR ABSCHEIDUNG VON MOLYBDÄNOXID-SCHICHTEN**
TARGET MATERIAL FOR DEPOSITION OF MOLYBDENUM OXIDE LAYERS
MATÉRIAU CIBLE PERMETTANT LE DÉPOT DES COUCHES D'OXYDE DE MOLYBDÈNE

(43) Veröffentlichungstag der Anmeldung: 10.04.2019
(73) Patentinhaber: Plansee SE, 6600 Reutte (AT)
(72) Erfinder: Franzke, Enrico, 6600 Reutte (AT); Köstenbauer, Harald, 6600 Reutte (AT); Winkler, Jörg, 6600 Reutte (AT); Lorenz, Dominik, 6600 Reutte (AT); Leiter, Thomas, 6600 Reutte (AT)
(74) Vertreter: Ciesla, Bettina

(56) Entgegenhaltungen:
- PACHLHOFER JULIA M ET AL: "Non-reactive dc magnetron sputter deposition of Mo-O thin films from ceramic MoOxtargets", SURFACE AND COATINGS TECHNOLOGY, vol. 332, 18 March 2017 (2017-03-18), pages 80 - 85, XP085293368, ISSN: 0257-8972, DOI: 10.1016/J.SURFCOAT.2017.07.083
- OKAMOTO H: "Supplemental Literature Review of Binary Phase Diagrams: Ag-Yb, Al-Co, Al-I, Co-Cr, Cs-Te, In-Sr, Mg-Tl, Mn-Pd, Mo-O, Mo-Re, Ni-Os, and V-Zr", JOURNAL OF PHASE EQUILIBRIA AND DIFFUSION, SPRINGER NEW YORK LLC, US, vol. 37, no. 6, 18 July 2016 (2016-07-18), pages 726 - 737, XP036102249, ISSN: 1547-7037, [retrieved on 20160718], DOI: 10.1007/S11669-016-0487-6
- MONK P M S ET AL: "The effect of doping electrochromic molybdenum oxide with other metal oxides: Correlation of optical and kinetic properties", SOLID STATE IONICS, NORTH HOLLAND PUB. COMPANY. AMSTERDAM; NL, NL, vol. 80, no. 1, 1 August 1995 (1995-08-01), pages 75 - 85, XP004050297, ISSN: 0167-2738, DOI: 10.1016/0167-2738(95)00130-X

## Beschreibung

Die vorliegende Erfindung betrifft ein elektrisch leitfähiges Targetmaterial aus Molybdänoxid, ein Verfahren zu dessen Herstellung sowie eine Verwendung des Targetmaterials.

Targetmaterialien aus Molybdänoxid (MoOₓ) werden in Kathodenzerstäubungsanlagen wie PVD-Beschichtungsanlagen (PVD engl. physical vapour deposition) verwendet, um molybdänoxidhaltige Schichten in einem Vakuumprozess aus der Gasphase abzuscheiden. Bei diesem Beschichtungsprozess (Sputterprozess) werden die schichtbildenden Teilchen aus dem (Sputter-)Target in die Gasphase übergeführt und durch Kondensation dieser Teilchen - gegebenenfalls unter Zufuhr von Sauerstoff als Reaktivgas ("reaktives Sputtern") - bildet sich auf dem zu beschichtenden Substrat eine entsprechende molybdänoxidhaltige Schicht aus.

Molybdänoxidschichten, deren Eigenschaften gegebenenfalls durch Hinzufügen von Dotierungselementen modifiziert werden können, haben interessante optische Eigenschaften und finden deshalb insbesondere Anwendung bei Schichtstrukturen in optischen bzw. optoelektronischen Applikationen wie beispielsweise elektronischen Displays. Ein Anwendungsbeispiel von Molybdänoxidschichten ist JP2013020347 zu entnehmen, wo metallische Leiterbahnen innerhalb des Displays eines kapazitiven Berührungssensors (Engl.: touch screen) durch eine lichtabsorbierende Schicht aus MoOₓ abgedeckt werden, um unerwünschte Reflexionen der metallischen Leiterbahnen zu unterdrücken.

Wichtige Eigenschaften wie Lichtabsorptions-, Lichtreflexions-, Lichttransmissionsgrad, Ätzrate (relevant bei anschließender Strukturierung der abgeschiedenen Schichten mittels Fotolithographie in Verbindung mit einem nasschemischen Ätzprozess), thermische Stabilität sowie Stabilität gegenüber weiteren im Fertigungsprozess eingesetzten Chemikalien (beispielsweise Stabilität gegenüber Fotolack-Entwickler bzw.-Entferner) hängen von der genauen stöchiometrischen Zusammensetzung x der abgeschiedenen MoOₓ - Schicht bzw. den zugefügten Dotierungselementen ab. In vielen Anwendungen wie beispielsweise bei dem oben genannten kapazitiven Berührungssensor werden MoOₓ - Schichten gefordert, in denen das Molybdänoxid in einer substöchiometrischen Zusammensetzung vorliegt, d.h. das Oxid hat unbesetzte Sauerstoff-Valenzen und es liegen in der abgeschiedenen MoOₓ - Schicht Sauerstofffehlstellen vor. Insbesondere substöchiometrische MoOₓ - Schichten mit einem x-Bereich von MoO_{2.5} bis MoO_{2.98} sind aufgrund ihrer elektro-optischen Eigenschaften für derartige Anwendungen von besonderem Interesse. Sie absorbieren Licht im sichtbaren Wellenlängenbereich und sind gleichzeitig noch ausreichend elektrisch leitfähig (Flächenwiderstand < 20 kΩ/□ bzw. <20kΩ/Square), in der Regel sind sie halbleitend.

Die einfachste Möglichkeit zur Herstellung solcher substöchiometrischen MoOₓ Schichten basiert auf einem metallischen Molybdäntarget, das in einer entsprechend eingestellten Argon- und Sauerstoff-Gasatmosphäre reaktiv gesputtert wird, sodass neben Molybdän auch Sauerstoffatome in die abgeschiedene Schicht eingelagert werden. Um Schichten mit homogenen Eigenschaften, insbesondere hinsichtlich Schichtdicke und Stöchiometrie (d.h. Sauerstoffgehalt bzw. Dotandenkonzentration) zu erzielen, ist beim reaktiven Sputtern in der Umgebung des Substrats eine Atmosphäre mit präziser, zeitlich und räumlich gleichmäßiger Sauerstoffkonzentration bereitzustellen. Dies ist nur mit Hilfe sehr aufwändiger und teurer Prozesstechnik realisierbar und daher mit entsprechend hohen Kosten verbunden. Zudem treten beim reaktiven Sputtern bei Änderung des Sauerstoffpartialdrucks (z.B. beim Anlaufen der Anlage) für die Prozessstabilität nachteilige Hysterese-Effekte auf.

Neben metallischen Targets sind oxidkeramische Targetmaterialien wie MoO₂ Targets (US 2006/0165572 A1) oder Targetmaterialien mit substöchiometrischer Zusammensetzung (DE10 2012 112 739 und EP 0 852 266 A1) bekannt. US 2006/0165572 A1 offenbart ein Targetmaterial mit mindestens 99 Gew.% MoO₂. Dieses Targetmaterial beinhaltet allerdings zu wenig Sauerstoff, um damit ohne zusätzlichen Sauerstoff als Reaktivgas MoOₓ Schichten mit x > 2 abscheiden zu können.

DE10 2012 112 739 offenbart ein MoOₓ Targetmaterial mit substöchiometrischer Zusammensetzung, wobei die Zusammensetzung des Targetmaterials der Stöchiometrie in der abzuscheidenden Schicht angenähert ist. Für die Feinanpassung der Schichtstöchiometrie ist aber weiterhin eine, wenn auch im Vergleich zum Metalltarget oder MoO₂ Target geringere, Zufuhr von Sauerstoff erforderlich, was sich wie bereits oben erwähnt nachteilig auf die Qualität der abgeschiedenen Schichten auswirken kann. Nähere Angaben zur Mikrostruktur des verwendeten MoOₓ Targetmaterials fehlen. Äußerst nachteilig sind zudem die erzielbaren relativen Dichten des Targetmaterials. Für das Ausführungsbeispiel eines substöchiometrischen Oxids Nb-Mo-Oₓ wird eine relative Dichte von 85% angegeben. Seitens der Betreiber von Beschichtungsanlagen werden aber Targetmaterialien mit möglichst hoher relativer Dichte, insbesondere >95%, nachgefragt, um beim Beschichtungsprozess das Risiko von Blitzentladungen (engl.: arcs), welche unerwünschte Partikelbildung in der abgeschiedenen Schicht bewirken können, zu verringern.

EP 0 852 266 B1 bezieht sich allgemein auf Sputtertargets aus substöchiometrischen Metalloxiden, als einziges konkretes Anwendungsbeispiel mit Molybdän wird in Beispiel 16 ein MoO_{2.95} Targetmaterial erwähnt. Konkrete Angaben zur Mikrostruktur des Targets und dem verwendeten Ausgangspulver zur Herstellung des Targetmaterials fehlen. Naheliegend wäre, dass ein anreduziertes MoO₃ Pulver oder eine Pulvermischung mit sehr hohem (>90 Gew.%) MoO₃-Anteil verwendet wurde. Bei der Herstellung des Targets wird lediglich auf den Herstellungsprozess für ein aus Nb₂O₅-Pulver hergestelltes Target verwiesen, welches mittels Heißpressens bei Temperaturen zwischen 1100 - 1400°C, einer Haltezeit von 1 h und angelegtem Druck von 50 kg/cm² kompaktiert wurde. Es ist völlig unklar, wie diese Nb₂O₅-Prozessbedingungen auf die Herstellung eines kompakten MoO_{2.95} Targets übertragen werden können, da der Schmelzpunkt von MoO₃ lediglich 795°C beträgt und sich daher das Pulver in dem angeblich verwendeten Temperaturbereich bereits vollständig verflüssigt hätte. Das in EP 0 852 266 B1 kurz angedeutete Plasmaspritzen ist zur Erzeugung von MoOₓ Targetmaterial mit den geforderten hohen relativen Dichten von über 95% nicht geeignet. Bei eigenen Versuchen der Anmelderin konnte mittels Plasmaspritzen MoOₓ-Targetmaterial nur mit relativen Dichten im Bereich von 85 - 90% erzielt werden.

Der Sauerstoffgehalt einer abgeschiedenen Schicht ist zwar proportional zum Sauerstoffgehalt x des Targetmaterials MoOₓ, er hängt aber empfindlich von der Größe, Geometrie und konstruktiven Auslegung der Beschichtungsanlage (bspw. vom Abstand Target-Substrat bzw. von der Position der Vakuum-Kammerabsaugung oder der Position des Ar-Sputtergas-Einlasses) ab. Um eine Schicht mit einem gewünschten Sauerstoffgehalt herzustellen, werden bei unterschiedlichen Anlagen individuelle Targets mit unterschiedlichem Sauerstoffgehalt benötigt. An die Hersteller von Targetmaterialien besteht daher die zusätzliche Anforderung, dass der Sauerstoffgehalt des Targetmaterials über einen möglichst großen Konzentrationsbereich in möglichst feinen Schritten oder bestenfalls kontinuierlich (analog) einstellbar ist.

Der Artikel "Non-reactive dc magnetron sputter deposition of Mo-O thin films from ceramic MoOx targets" (Pachlhofer Julia et al, Surface & Coatings Technology 332 (2017) 80-85) beschäftigt sich mit Molybdänoxid-Schichten, die unter Verwendung von nicht näher beschriebenen MoOₓ Targetmaterialien (mit x=2.5, 2.6, 2.7 und 2.8) hergestellt wurden. Nähere Angaben zur Mikrostruktur der verwendeten MoOₓ Targetmaterialien fehlen, es ist ausschließlich die allgemeine Herstellungsmethode (pulvermetallurgisch) und das Gesamtverhältnis Sauerstoff zu Molybdän bekannt.

Die Aufgabe der vorliegenden Erfindung besteht darin, ein Targetmaterial für die Herstellung von MoOₓ Schichten weiterzuentwickeln, sodass qualitativ hochwertige Schichten mit gleichmäßiger Schichtdicke und homogener Zusammensetzung abgeschieden werden können. Das Targetmaterial soll eine möglichst hohe Dichte aufweisen, um eine gute Prozessstabilität und eine geringe Neigung zur Partikelbildung zu gewährleisten. Das Targetmaterial soll zudem für einen breiten Parameterbereich x, insbesondere für 2,53 ≤ x ≤ 2,88, der substöchiometrischen Zusammensetzung von MoOₓ einstellbar sein. Damit es in DC ("direct current"; Gleichstrom) bzw. in gepulsten DC-Sputterverfahren eingesetzt werden kann, muss das Targetmaterial zudem elektrisch leitfähig sein, d.h. sein spezifischer Widerstand sollte kleiner 10 Ohm cm betragen, bzw. die spezifische elektrische Leitfähigkeit sollte größer 10 S/m sein. Es soll weiters ein Herstellungsverfahren für ein derartiges Molybdänoxid-Targetmaterial bereitgestellt werden.

Die Aufgabe wird durch das leitfähige Targetmaterial gemäß Anspruch 1 und durch das Herstellungsverfahren gemäß Anspruch 13 gelöst. Vorteilhafte Weiterentwicklungen der Erfindung sind den Unteransprüchen zu entnehmen.

Das erfindungsgemäße oxidkeramische Targetmaterial ist elektrisch leitfähig. Es zeigt auf einer makroskopischen Skala einen homogenen Aufbau, auf einer mikroskopischen Skala ist es in mindestens zwei verschiedene Molybdänoxid-Phasen strukturiert: Neben einer MoO₂-Phase mit einem Anteil von 2-20 Vol.% weist es einen substöchiometrischen Molybdänoxid-Phasenanteil von mindestens 60 Vol.% auf. Der substöchiometrische Molybdänoxid-Phasenanteil beträgt dabei insbesondere 60 - 98 Vol.%. Der substöchiometrische Molybdänoxid-Phasenanteil wird durch eine oder mehrere substöchiometrische MoO_{3-y}-Phase(n), wobei y jeweils im Bereich von 0,05 bis 0,25 ist, gebildet. Optional kann das Targetmaterial noch eine MoO₃-Phase mit einem Anteil von 0-20 Vol.% aufweisen. Neben diesen Molybdänoxiden können im Targetmaterial herstellungsbedingte Verunreinigungen wie beispielsweise Wolfram (W), Natrium (Na), Kalium (K), Antimon (Sb), Vanadium (V), Chrom (Cr), Eisen (Fe), Kohlenstoff (C) und Stickstoff (N) vorhanden sein, die Menge derartiger Verunreinigungen liegt typischerweise im Bereich von unter 1000 ppm. Diese herstellungsbedingten, sehr geringen Verunreinigungen werden im Folgenden bei der Analyse der Mikrostruktur des Targetmaterials ausgeklammert und nicht weiter berücksichtigt (z.B. nicht als eigene Phase betrachtet). Die Volumenangaben der verschiedenen Molybdänoxid-Phasen sind normiert und Relativangaben bezüglich des Gesamtvolumens, das von den materiellen Teilchen (Körnern) des Targetmaterials eingenommen wird; das von den Poren des Targetmaterials eingenommene Volumen ist von diesem Gesamtvolumen ausgeklammert. Die Volumenangaben der einzelnen Molybdänoxid-Phasen addieren sich daher alleine ohne das Porenvolumen auf 100%.

Das auf einer mikroskopischen Skala mehrphasige Targetmaterial hat folgende entscheidende Vorteile:
Durch die Koexistenz von mindestens zwei Phasen - einer MoO₂ Phase und mindestens einer substöchiometrischen MoO_{3-y} Phase - wird ein zusätzlicher Freiheitsgrad hinsichtlich des Sauerstoffgehalts des Targetmaterials geschaffen. Der Sauerstoffgehalt x des Targetmaterials MoOₓ (und damit verbunden der Sauerstoffgehalt der abgeschiedenen Schicht) kann über das Mengenverhältnis der koexistierenden Phasenanteile zueinander in einem breiten Parameterbereich von 2,53 ≤ x ≤ 2,88, insbesondere im wirtschaftlich besonders wichtigen Bereich von 2,6 < x < 2,8, sehr fein variiert und präzise eingestellt werden. Eine derartige Variation des Sauerstoffgehalts des Targetmaterials ist im Stand der Technik, bei dem das Targetmaterial nur in einer Phase vorliegt, nicht möglich, da der Sauerstoffgehalt x des Targetmaterials MoOₓ auf eine kleine Anzahl diskreter Werte beschränkt ist: x=2 bei einem MoO₂ Targetmaterial, x=2,75 bei einem Mo₄O₁₁ Targetmaterial, x=2,76 bei Mo₁₇O₄₇, x=2,8 bei Mo₅O₁₄; x=2,875 bei Mo₈O₂₃, x=2,89 bei Mo₉O₂₆ bzw. x=2,89 bei Mo₁₈O₅₂. Die hier aufgezählten Mo-Oxide sind diejenigen, die in der Fachliteratur am häufigsten erwähnt werden. Die Existenz weiterer Mo-Oxide, die nicht beschrieben oder noch nicht entdeckt sind, kann hier nicht ausgeschlossen werden. Beim Stand der Technik ist eine feinere Justierung des Sauerstoffgehalts x der abgeschiedenen Schichten nur mittels zugeführten Sauerstoff als Reaktivgas möglich.

Das Targetmaterial hat einen für viele Anwendungen bereits ausreichenden Sauerstoffgehalt, sodass beim Beschichtungsprozess die Zufuhr von zusätzlichem Sauerstoff nicht zwingend erforderlich ist. Der Beschichtungsprozess kann somit mit reinem Edelgas-Prozessgas (in der Regel Argon) durchgeführt werden. Die mit reaktivem Sputtern verbundenen Nachteile (aufwendige Prozesstechnik und -führung, potentielle Inhomogenitäten der abgeschiedenen Schicht) können daher vermieden werden. Zu beachten ist, dass bei Einsatz in einer reinen Edelgasatmosphäre ohne zusätzliche Sauerstoff-Zufuhr der Sauerstoffgehalt der abgeschiedenen Molybdänoxid-Schicht etwas geringer als der Sauerstoffgehalt des verwendeten Targetmaterials ist. Dies ist darauf zurückzuführen, dass beim Sputterprozess, bei dem das Sputtertarget in seine atomaren Einzelteile wie Molybdänatome, -Radikale und -Ionen, Sauerstoffatome, -Radikale und -Ionen sowie neutrale und geladene Molybdän-Sauerstoff-Cluster zerlegt wird, die Sauerstoff-Spezies als die leichteren und daher beweglicheren Komponenten teilweise zu Sauerstoffmolekülen (O₂) rekombinieren. Ein Teil dieser durch Rekombination entstandenen Sauerstoffmoleküle wird über die Vakuumpumpe aus dem Prozessbereich abgepumpt und geht auf diesem Weg für die Einlagerung in die abzuscheidende Schicht verloren. Diese geringfügige Sauerstoff-Verarmung kann durch Verwendung eines Molybdänoxid Targets, das im Vergleich zur abzuscheidenden Schicht einen entsprechend höheren Sauerstoffgehalt hat, kompensiert werden.

Auch wenn das mehrphasige Targetmaterial in einem reaktiven Sputterprozess zum Einsatz kommt, bietet es gegenüber den im Stand der Technik bekannten Targetmaterialien Vorteile. Beim erfindungsgemäßen Targetmaterial ist der zusätzlich benötigte Sauerstoff in der Regel deutlich geringer, da der Sauerstoffgehalt des Targetmaterials über einen großen Parameterbereich deutlich genauer für die gewünschte Zusammensetzung in der Schicht eingestellt werden kann. Die Nachteile vom reaktiven Sputtern (Hysterese-effekte, potentielle Inhomogenitäten der abgeschiedenen Schicht) sind bei niedrigerem Sauerstoffpartialdruck weniger stark ausgeprägt und treten daher bei Verwendung des erfindungsgemäßen Targetmaterials vermindert auf.

Insbesondere MoO₂ und die substöchiometrischen MoO_{3-y} Phasen tragen zu den zuvor erwähnten vorteilhaften Eigenschaften des Targetmaterials bei. MoO₂ zeichnet sich im Vergleich zu den anderen Molybdänoxid Phasen durch eine sehr hohe elektrische Leitfähigkeit von 1,25 x 10⁶ S/m aus. Die substöchiometrischen MoO_{3-y} Phasen weisen ebenfalls jeweils eine sehr hohe elektrische Leitfähigkeit auf (monoklines Mo₄O₁₁: 1,25 x 10⁶ S/m), bzw. sind elektrisch halbleitend (Angaben zur elektrischen Leitfähigkeit: Mo₁₇O₄₇: >2000 S/m; Mo₈O₂₃: 83 S/m; Mo₁₈O₅₂: 0,4 S/m; Mo₉O₂₆: 27 S/m). Die substöchiometrischen MoO_{3-y} Phasen, insbesondere Mo₄O₁₁, haben ferner sehr gute Sintereigenschaften, wodurch Sintern des verwendeten Ausgangspulvers zu einem kompakten Bauteil bereits bei niedrigen Temperaturen unterstützt wird. Sowohl MoO₂ als auch die substöchiometrischen MoO_{3-y} Phasen haben zudem einen niedrigen partiellen Dampfdruck. Der Dampfdruck ist ein wichtiger Prozessparameter beim Beschichtungsprozess, ein niedriger Dampfdruck trägt zur Stabilität des Beschichtungsprozesses bei.

Das im erfindungsgemäßen Targetmaterial optional vorhandene MoO₃ hat einen hohen relativen Sauerstoffgehalt und hilft so bei der Realisierung von Targetmaterialien mit sehr geringer Sauerstoff-Unterstöchiometrie (d.h. ein MoOₓ Targetmaterial mit x nahe 3). MoO₃ hat eine für MoO₃ charakteristische orthorhombische Struktur. In der vorliegenden Erfindung wird unter MoO₃ auch auf ein substöchiometrisches Molybdänoxid MoO_{3-y} mit sehr wenigen Sauerstofffehlstellen (0<y<0,05) Bezug genommen, das ebenfalls in einer orthorhombischen MoO₃-Struktur vorliegt und sich von MoO₃ mit exakter Stöchiometrie nur um einige wenige Sauerstofffehlstellen unterscheidet. Beispielsweise wird im Rahmen der vorliegenden Erfindung MoO_{2,96}, welches eine orthorhombische MoO₃-Struktur besitzt und im Vergleich zum exakt stöchiometrischen MoO₃ einige wenige Sauerstoff-Fehlstellen aufweist, auch als MoO₃ verstanden. Der Reduktionsgrad des Molybdänoxids kann anhand des Intensitätsverhältnisses der beiden Raman Nickschwingungen (Wagging-Schwingungen) bei 285 und 295 cm⁻¹ abgeschätzt werden (vgl. Phys. Chem. Chem. Phys., 2002, 4, 812-821).

MoO₃ zeichnet sich ebenfalls durch gute Sintereigenschaften aus, im Gegensatz zu den anderen MoOₓ Phasen ist MoO₃ aber elektrisch isolierend (die Leitfähigkeit von α-MoO₃ beträgt lediglich 1 x 10⁻⁶ S/m) und zudem wasserlöslich. Ein Targetmaterial mit einer elektrisch isolierenden Phase wie MoO₃, welches in eine elektrisch halbleitende oder elektrisch leitfähige Matrix eingebettet ist, neigt im Sputterprozess zum "Arcen" (Blitzentladungen) und in die abgeschiedenen Schichten sind verhältnismäßig viele Partikel ("Splashes") eingelagert. Die Wasserlöslichkeit von MoO₃ erschwert zudem die mechanische Bearbeitbarkeit des Targetmaterials. Mechanische Bearbeitungsschritte wie Schleifen, Schneiden, Drehen haben daher meist "trocken" zu erfolgen, d.h. ohne Kühlschmiermittel, wodurch die Bearbeitungsgeschwindigkeit signifikant herabgesetzt wird und Kosten für diese Prozessschritte steigen. Des Weiteren besitzt MoO₃ einen hohen Dampfdruck und neigt bereits ab Temperaturen von 700°C zur Sublimation, was sich für den Herstell- bzw. Kompaktierungsprozess nachteilig auswirkt. Des Weiteren besteht die Gefahr, daß MoO₃ während der Verwendung des Sputtertargets im Beschichtungsprozess selektiv sublimiert, und sich auf diese Art die Phasenzusammensetzung des Targets während des Betriebs verändert. Aus diesen Gründen sollte MoO₃ daher im Targetmaterial nach Möglichkeit vermieden werden. In einer bevorzugten Ausführungsform beträgt der Anteil der MoO₃-Phase ≤ 1 Vol.%. Besonders bevorzugt liegt MoO₃ im Targetmaterial höchstens in Spuren vor und ist im Targetmaterial insbesondere nicht nachweisbar.

Bevorzugt ist überwiegend ein substöchiometrisches Molybdänoxid der Hauptbestandteil des Targetmaterials: der substöchiometrische Molybdänoxid-Phasenanteil des Targetmaterials beträgt gemäß einer Weiterbildung mindestens 85 Vol. %, er liegt insbesondere im Bereich von 85-98 Vol.%. Der Anteil der MoO₂-Phase liegt dabei bevorzugt im Bereich von 2-15 Vol.%. In einer vorteilhaften Ausführungsform liegt der Anteil der MoO₂-Phase insbesondere im Bereich von 2-7 Vol.%, während der substöchiometrische Molybdänoxid-Phasenanteil im Bereich von 93 -98 Vol.% liegt.

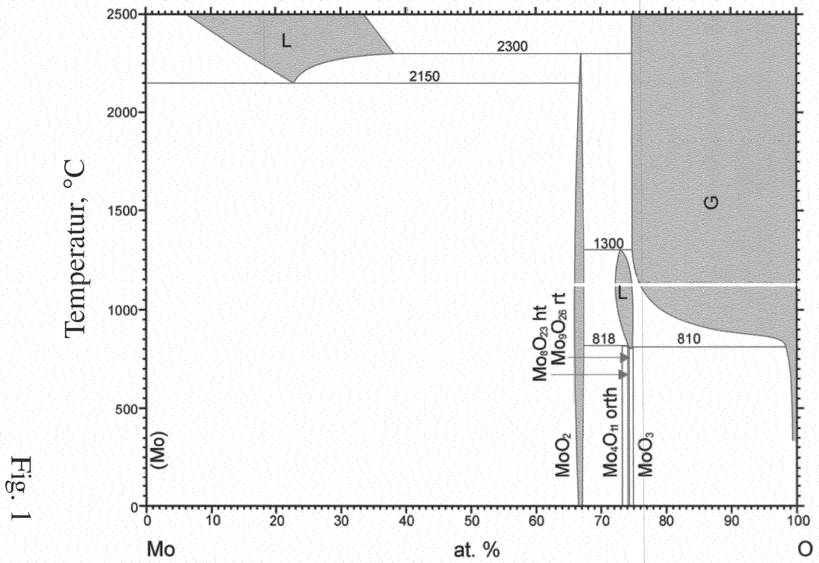

Die neben der MoO₂-Phase und der optionalen MoO₃-Phase vorliegende(n) substöchiometrischen MoO_{3-y}-Phase(n) können insbesondere Mo₄O₁₁ (entspricht y=0,25), Mo₁₇O₄₇ (y=0,24), Mo₅O₁₄ (y=0,2), Mo₈O₂₃ (y=0,125), Mo₉O₂₆ (y=0,11) oder Mo₁₈O₅₂ (y=0,11) sein. Mo₄O₁₁ kann sowohl als η-Oxid in einer monoklinen Kristallstruktur (Niedertemperatur Form) als auch als γ-Oxid mit rhombischer Kristallstruktur (Hochtemperatur Form) vorliegen. Mo₁₇O₄₇, Mo₅O₁₄, Mo₁₈O₅₂ werden auch als Magnéli-Phasen bezeichnet. Das binäre Phasendiagramm des Systems Molybdän-Sauerstoff ist in Fig. 1 dargestellt.

Es hat sich gezeigt, dass bei dem zuvor angegebenen vorteilhaften Targetmaterial (substöchiometrischer Molybdänoxid-Phasenanteil im Bereich von 85-98 Vol.%, Anteil der MoO₂-Phase im Bereich von 2-15 Vol.%) sowohl hohe elektrische Leitfähigkeit als auch eine hohe Dichte erzielt werden konnte. Hervorragende Eigenschaften insbesondere hinsichtlich erzielbarer Dichte können mit Targetmaterialien erreicht werden, welche zu mindestens 45 Vol.% aus der substöchiometrischen Phase Mo₄O₁₁ bestehen.

Die Bestimmung der Volumenanteile der unterschiedlichen Molybdänoxid-Phasen und der Dichte des Targetmaterials erfolgen anhand eines repräsentativen Querschnitts einer Probe, wobei - wie in dem Fachgebiet üblich - Volumenangaben aus an der Schnittfläche gemessenen Flächenanteilen abgeleitet werden. Mittels Trockenpräparation wird ein metallographischer Schliff der Probe hergestellt und anschließend im Licht- bzw. Elektronenmikroskop analysiert, wobei zur ortsaufgelösten Bestimmung der Molybdänoxid-Phasen zusätzliche Analysemethoden wie z.B. Raman-Spektrometrie oder bei Verwendung eines Rasterelektronenmikroskops ein Rückstreuelektronendetektor (BSE detector, engl.: backscatter electron detector) benötigt werden. Die bei den nachfolgenden Ausführungsbeispielen verwendete Methode zur Bestimmung der Molybdänoxid-Phasenanteile basiert auf Raman-Mikroskopie, bei der die zu analysierende Probenoberfläche punktweise mit einem Laserstrahl abgerastert, und für jeden Messpunkt ein vollständiges Raman-Spektrum erstellt wird ("Raman-Mapping"). Durch Vergleich des erhaltenen Raman-Spektrums für jeden Messpunkt mit Referenzspektren von einzelnen, reinen Molybdänoxiden bzw. substöchiometrischen Molybdänoxiden, wird jedem Messpunkt eine entsprechende Molybdänoxid-phase zugeordnet und so eine zweidimensionale Darstellung der Phasenzusammensetzung der Probe erstellt, aus der sich dann die Flächenanteile, bzw. die Volumenanteile, der verschiedenen Phasen berechnen lassen.

Neben den Molybdänoxidphasen können im Targetmaterial zusätzlich ein oder mehrere Dotanden mit einem insgesamten Stoffmengenanteil von höchstens 20 Mol% vorliegen. Mit Dotand wird auf ein metallisch oder oxidisch vorliegendes, von Molybdän verschiedenes Metall Bezug genommen; der Anteil eines einzelnen Dotanden im Targetmaterial beträgt zwischen 0,5 Mol% und 20 Mol%. Die Stoffmengenangaben beziehen sich dabei auf die Menge des - gegebenenfalls oxidisch gebundenen - Metalls und nicht auf die Menge eines etwaigen Metalloxids. Der Dotand dient der gezielten Modifikation der mit dem Targetmaterial hergestellten Schicht und ist deutlich, schon alleine aufgrund seines Stoffmengenanteils von mindestens 0,5 Mol% von den früher erwähnten herstellungsbedingten Verunreinigungen, deren typische Konzentration im Bereich von höchstens 1000 ppm liegt, unterscheidbar. Mit Stoffmengenanteilen von bis zu 20 Mol% liegt der Dotand in deutlich höheren Konzentrationen als beispielsweise in der Halbleiterelektronik üblich vor. Höhere Dotandenkonzentrationen (> 2 Mol%) können mittels Röntgenfluoreszenzanalyse (RFA) oder EDX-Detektor (energiedispersiver Röntgenspektroskopie) im Rasterelektronenmikroskop (REM), niedrigere mittels induktiv-gekoppelter Plasma-Massenspektrometrie (ICP-MS) quantitativ bestimmt werden.

Als Dotand können insbesondere ein oder mehrere Metalle aus der Gruppe Tantal, Niob, Titan, Chrom, Zirkon, Vanadium, Hafnium, Wolfram gewählt werden. Tantal (Ta), Niob (Nb) oder eine Mischung von Niob und Tantal sind bevorzugte Dotanden, mit denen die Ätzrate der abgeschiedenen Schichten modifiziert werden kann, ohne dass die elektro-optischen Eigenschaften negativ beeinflusst werden. Reine Molybdänoxid-Schichten haben in der Regel eine zu hohe Ätzrate. Die Ätzrate der abgeschiedenen Schicht sinkt mit steigendem Anteil an Tantal oder Niob.

Bevorzugt liegt der Dotand im Targetmaterial oxidisch gebunden vor. Ein Molybdänoxid-Targetmaterial mit oxidisch gebundenen Dotand ist üblicherweise einem Targetmaterial vorzuziehen, bei dem der Dotand als metallische Beimischung vorliegt, da sich die elektrische Leitfähigkeit des Metalls meist signifikant (um eine bis mehrere Größenordnungen) von der elektrischen Leitfähigkeit der verschiedenen Molybdänoxide unterscheidet. Ein solches Targetmaterial mit stark unterschiedlicher elektrischer Leitfähigkeit neigt während des Beschichtungsprozesses zum Arcen bzw. Partikelbildung und ist für die Abscheidung von hochwertigen, partikelfreien Dünnschichten weniger geeignet.

Der oxidisch gebundene Dotand kann mit den Molybdänoxiden eine Mischphase bilden. Der Dotand kann auch zumindest anteilig als eigene Oxid-Phase vorliegen, welche in Form von Domänen in das restliche Molybdänoxid-Targetmaterial eingebettet ist. Die Oxid-Phase kann dabei zumindest anteilig durch stöchiometrische bzw. substöchiometrische Oxide des Dotanden und/oder Mischoxide des Dotanden mit Molybdän gebildet sein.

Im Beispiel von Tantal als Dotand kann der Dotand zumindest anteilig als eigene Phase aus Tantaloxid, insbesondere aus Ta₂O_{5-y} mit 0 ≤ y ≤ 0,05 vorliegen.

Im Beispiel von Niob als Dotand kann der Dotand zumindest anteilig als eigene Phase aus Nioboxid, insbesondere aus Nb₂O_{5-y} mit 0 ≤ y ≤ 0,05 vorliegen.

In einer bevorzugten Ausführungsform ist der substöchiometrische Molybdänoxid-Phasenanteil als Matrix ausgebildet, in welche die weiteren Phasen eingebettet sind. Der substöchiometrische Molybdänoxid-Phasenanteil durchzieht dabei das Targetmaterial in einem zusammenhängenden, perkolierenden Netzwerk, in welchen inselförmige Bereiche (Domänen) mit den weiteren Molybdänoxidphasen (MoO₂, gegebenenfalls MoO₃) oder gegebenenfalls Domänen mit Dotanden ausgebildet sind. Im metallographischen Schliff sind die Domänen als Flächen erkennbar. Diese perkolierende Mikrostruktur beeinflusst positiv die elektrische Leitfähigkeit des Targets. Die Domänen haben typischerweise eine Ausdehnung in der Größenordnung von 100 µm, wobei bei größerem Anteil von MoO₃ die Domänen mit MoO₃-Phase auch etwas größer sein können (mit einer Ausdehnung von bis zu 300µm). Liegen mehrere substöchiometrische MoO_{3-y} Phasen vor, so kann ein zusammenhängendes, perkolierendes Netzwerk durch die verschiedenen substöchiometrischen Molybdänoxid-Phasen gemeinsam, aber auch durch die mengenmäßig am höchsten vorliegende substöchiometrische Molybdänoxid-Phase alleine, insbesondere durch Mo₄O₁₁, gebildet sein. Auf makroskopischer Skala ist die dreidimensionale Struktur des Targetmaterials im Wesentlichen isotrop, d.h. es liegt keine Richtungsabhängigkeit der Materialeigenschaften vor.

Mit dem erfindungsgemäßen mehrphasigen Ansatz lassen sich Targetmaterialien mit einer hohen relativen Dichte, insbesondere mit einer relativen Dichte von mindestens 95%, insbesondere von mindestens 98%, erzielen. Bevorzugt beträgt die relative Dichte des Targetmaterials mindestens 99%. Besonders vorteilhaft ist die relative Dichte des Targetmaterials mindestens 99,5 %. Ein kompaktes Targetmaterial mit einer hohen relativen Dichte ist für die Qualität der abgeschiedenen Schichten wichtig, da weniger dichte Targetmaterialien aufgrund ihrer höheren Porosität zu einem instabileren und schwerer steuerbaren Abscheideprozess führen (bei Targetmaterialien mit zu geringer relativer Dichte besteht die Gefahr von Blitzentladungen bzw. "Arcs", welche in der Regel zu einer unerwünschten Partikelbildung in der abgeschiedenen dünnen Schicht führen). Targetmaterialien mit zu geringer relativer Dichte neigen außerdem dazu, Wasser bzw. andere Verunreinigungen aufzunehmen, was ebenfalls zu einem schwerer kontrollierbaren Beschichtungsprozess führen kann. Die Bestimmung der relativen Dichte erfolgt mittels digitaler Bildanalyse anhand von lichtmikroskopischen Bildaufnahmen des metallographischen Schliffs, bei dem der relative Flächenanteil der Poren (d.h. Flächenanteil der Poren relativ zur untersuchten Gesamtfläche) ausgewertet wird. Die Dichte wird als arithmetisches Mittel aus drei derartigen Porositätsmessungen berechnet.

Bevorzugt beträgt die elektrischen Leitfähigkeit des Targetmaterials mindestens 10 S/m. Die elektrische Leitfähigkeit kann mittels handelsüblicher Geräte durch Transportmessung, beispielsweise einer Vierpunktmessung, gemessen werden. Mit einer höheren elektrischen Leitfähigkeit können die Abscheiderate und die Prozessstabilität erhöht, sowie die Kosten für den Beschichtungsprozess gesenkt werden.

In einer bevorzugten Ausführungsform beträgt der Sauerstoffgehalt des Targetmaterials zwischen 71,4 und 74,5 At.%, insbesondere zwischen 72 und 74 At:%. Der Sauerstoffgehalt kann z.B. mit Hilfe eines EDX-Detektors (energiedispersive Röntgenspektroskopie) in einem Rasterelektronenmikroskop (REM) bestimmt werden, bzw. durch Heißextraktionsanalyse (Trägergasheißextraktion), in dem die zu analysierende Mo-Oxidprobe mit metallischem Molybdän, dessen Sauerstoffgehalt (Blindwert) zuvor in einer separaten Messung bestimmt wurde, im Verhältnis 1:10 bis 1:1000 "verdünnt" wird. Es lassen sich damit - abhängig von der Größe und konstruktiven Auslegung der verwendeten Beschichtungsanlage - ohne zusätzliche Sauerstoffzufuhr während des Beschichtungsprozesses Molybdän-Oxidschichten mit bis zu 74 At.% Sauerstoff herstellen.

Die Erfindung betrifft auch ein Herstellungsverfahren des zuvor beschriebenen Targetmaterials. Zur Herstellung eines derartigen Targetmaterials wird ein molybdänoxidhaltiges Pulver bzw. eine molybdänoxidhaltige Pulvermischung mit einem für das gewünschte Targetmaterial angepassten Sauerstoffgehalt verwendet. Ein bevorzugtes Ausgangspulver ist eine Pulvermischung aus MoO₂ und MoO₃, gegebenenfalls ergänzt mit geringen Anteilen an substöchiometrischen Molybdänoxiden wie insbesondere Mo₄O₁₁. Beide Oxide, MoO₂ und MoO₃, sind leicht zugängliche, günstige und unter Umgebungsbedingungen thermodynamisch stabile, einfach zu handhabende Rohstoffe. Substöchiometrische Oxide können durch Reduktion von MoO₃-Pulver in einer entsprechenden Atmosphäre wie H₂ hergestellt werden. Die Ausgangspulver werden in einem entsprechenden Mengenverhältnis eingewogen, um eine Pulvermischung mit einem insgesamten Sauerstoffgehalt, welcher dem Sauerstoffgehalt des gewünschten Targetmaterials entspricht, zu erhalten. Die Pulver werden anschließend trocken gemahlen und in einer Mischkammer intensiv vermischt. Der Mahlvorgang kann unter Beigabe von Mahlkugeln erfolgen, um Agglomerate und Klumpen aus Partikeln zu zerkleinern und den Mischprozess zu beschleunigen. Der optionale Dotand kann als entsprechend eingewogenes Metall-Pulver oder entsprechend eingewogenes Metalloxid-Pulver vor dem Mahlvorgang der molybdänoxidhaltigen Pulvermischung beigemengt werden. Bei Tantal bzw. Niob als Dotand bietet die Verwendung eines Tantaloxid- bzw. Nloboxidpulvers (Ta₂O₅ bzw. Nb₂O₅) den Vorteil, dass diese Pulver in einer feineren Korngröße als die entsprechenden Metallpulver verfügbar sind und dadurch eine homogenere Verteilung des Dotanden im Targetmaterial erzielbar ist. Die erhaltene Pulvermischung weist eine mittlere Partikelgröße mit einem Durchmesser kleiner als 150 µm auf. Zur Bestimmung der mittleren Partikelgröße wird die Malvern Laserbeugung (bei der Laserbeugung werden Partikelgrößenverteilungen durch Messung der Winkelabhängigkeit der Intensität von gestreutem Licht eines Laserstrahls, der eine dispergierte Partikelprobe durchdringt, ermittelt) herangezogen. Die so hergestellte Pulvermischung wird in eine Form, beispielsweise in eine Graphitform gefüllt, und anschließend verdichtet, wobei der Verdichtungsschritt unter Anwendung von Druck und/oder Temperatur, insbesondere von Druck und Temperatur, erfolgen kann. Geeignete Verdichtungsverfahren sind beispielsweise Spark Plasma Sintern (SPS), Heißpressen, Heiß-isostatisch-Pressen oder Pressen-Sintern. Die Verdichtung erfolgt dabei insbesondere bei Temperaturen zwischen 600 und 900 °C und Pressdrücken zwischen 15 und 110 MPa.

Bei einer Verdichtung mittels SPS erfolgt die Verdichtung über Druck und Temperatur, wobei die Wärme intern durch einen durch die Pulvermischung geführten elektrischen Strom erzeugt wird. SPS zeichnet sich durch hohe Heiz- und Abkühlraten und kurze Prozesszeiten aus. Bevorzugt findet die Verdichtung mittels SPS bei Temperaturen zwischen 600 und 750 °C und Pressdrücken zwischen 15 und 45 MPa in Vakuum oder Schutzgasatmosphäre (z.B. Argon) statt.

Bei einer Verdichtung mittels Heißpressen erfolgt die Verdichtung ebenfalls über Druck und Temperatur, wobei die Wärme von außerhalb über eine beheizte Form zugeführt wird. Bevorzugt erfolgt die Verdichtung mittels Heißpressen bei Temperaturen zwischen 650 und 850 °C und bei Pressdrücken zwischen 15 und 80 MPa in Vakuum- oder Schutzgasatmosphäre (z.B. Argon). Bei einer Verdichtung mittels Heiß-isostatisch Pressen erfolgt die Verdichtung ebenfalls über Druck und Temperatur. Bevorzugte Prozessparamter sind Temperaturen zwischen 650 und 900 °C und Drücke zwischen 60 und 110 MPa. Die Verdichtung des Pulvers findet dabei üblicherweise in einer abgeschlossenen Kapsel statt. Bei einer Verdichtung mittels Pressen-Sintern wird das Pulver bzw. die Pulvermischung zu einem Grünling gepresst und dieser anschließend durch Wärmebehandlung unterhalb der Schmelztemperatur in einer geeigneten Sinteratmosphäre gesintert.

Während des Verdichtungsprozesses werden die Ausgangspulver in einer Festphasenreaktion, bzw. je nach chemischer Zusammensetzung und Prozessbedingungen auch Flüssigphasenreaktionen, bzw. Mehrphasenreaktionen (z.B. fest-flüssig) in ein mehrphasiges (in Sinne von mehrkomponentig) Targetmaterial umgewandelt. Die dabei ablaufenden Reaktionen ähneln einer Komproportionierung: MoO₃ wird zu verschiedenen substöchiometrischen Mo-Oxiden (z.B. Mo₁₈O₅₂, MoO₄O₁₁, ...) reduziert, während MoO₂ zu verschiedenen substöchiometrischen Mo-Oxiden oxidiert wird. Während des Kompaktierungsprozesses wird also in der Pulvermischung enthaltenes MoO₃ abgebaut, d.h. der Volumenanteil der MoO₃-Phase wird signifikant verringert. Auf diese Weise kann leicht verfügbares MoO₃ als Pulver eingesetzt werden, es ist aber - je nach Prozessführung - im fertig kompaktierten Target nur noch in sehr geringem Umfang oder gar nicht mehr nachweisbar, da es zu substöchiometrischen Mo-Oxiden umgewandelt wird. Der Anteil von MoO₃, der sich wie eingangs beschrieben im Targetmaterial eher nachteilig auswirkt, kann so verringert bzw. vollständig vermieden werden. Ein metallisch eingesetzter Dotand wie Tantal oder Niob wird aufgrund der meist hohen Affinität (Oxid-Bildungsenthalpie Δ*H_{f}*) des Dotanden zum Sauerstoff in einer Festkörperreaktion oxidiert, in der Regel vollständig zum jeweiligen Metalloxid (im Fall von Ta zu Ta₂O₅ bzw. im Fall von Nb zu Nb₂O₅). Der Dotand kann im Targetmaterial zumindest anteilig auch als substöchiometrisches Oxid (bspw. Ta₂O_{5-y} mit 0 ≤ y ≤ 0,05 bzw. Nb₂O_{5-y} mit 0 ≤ y ≤ 0,05) oder als Molybdän-Mischoxid (Tantal-Molybdän-Mischoxid bzw. Niob-Molybdän-Mischoxid) vorliegen. Nach dem Verdichten kann eine mechanische Nachbearbeitung, beispielsweise durch spanabhebende Werkzeuge, zur gewünschten Endgeometrie bzw. zur Oberflächenaufbereitung (Einstellung einer gewünschten Rauigkeit der Oberfläche) erfolgen.

Das erfindungsgemäße Targetmaterial wird bevorzugt zur GasphasenAbscheidung von molybdänoxidhaltigen Schichten mittels eines DC ("direct current")-Sputterverfahrens bzw. eines gepulsten DC-Sputterverfahrens verwendet. Beim Gleichspannungssputtern, oder DC-Sputtern, wird zwischen dem als Kathode geschalteten Sputtertarget und einer Anode (in der Regel das Gehäuse der Beschichtungsanlage und/oder Abschirmbleche in der Vakuumkammer) eine Gleichspannung angelegt. Das DC-Sputterverfahren bzw. gepulste DC-Sputterverfahren erfolgt dabei in einer Edelgasatmosphäre, insbesondere einer Argongasatmosphäre, bevorzugt nicht-reaktiv ohne zusätzliche Zufuhr von Sauerstoff. Die dabei abgeschiedenen Schichten haben aufgrund der bereits erwähnten Sauerstoff-Verarmung beim Beschichtungsprozess einen etwas kleineren Sauerstoffgehalt als das verwendete Targetmaterial, der genaue Sauerstoffgehalt der abgeschiedenen Schichten hängt von der Größe und konstruktiven Auslegung der individuellen Beschichtungsanlage ab. Um Molybdänoxid-Schichten mit einem höheren Sauerstoffgehalt als dem des Targetmaterials herzustellen, kann das Targetmaterial auch reaktiv unter Zufuhr von höchstens 20 Vol.% Sauerstoff gesputtert werden. Da der Sauerstoffgehalt des Targetmaterials in einem breiten Parameterbereich eingestellt, und das Targetmaterial für die jeweilige Anwendung entsprechend individuell angepasst werden kann, ist im Regelfall die Menge an zugeführtem Sauerstoff vergleichsweise niedrig. Die Nachteile vom reaktiven Sputtern (Hystereseeffekte, potentielle Inhomogenitäten der abgeschiedenen Schicht) wirken sich daher nicht so stark aus.

Weitere Vorteile und Zweckmäßigkeiten der Erfindung ergeben sich anhand der nachfolgenden Beschreibung von Ausführungsbeispielen unter Bezugnahme auf die beigefügten Figuren.

### Von den Figuren zeigen:

- Fig. 1:: Binäres Phasendiagramm des Systems Molybdän-Sauerstoff; Quelle: Brewer L., and Lamoreaux R.H. in Binary Alloy Phase Diagrams, II Ed., Ed. T.B. Massalski, 1990.
- Fig. 2:: Raman Referenzspektrum 1 (MoO₂), wobei die Intensität (Anzahl) (intensity (counts)) über der Raman-Verschiebung (cm⁻¹) (Raman shift (cm⁻¹)) aufgetragen ist.
- Fig. 3:: Raman Referenzspektrum 2 (Mo₄O₁₁).
- Fig. 4:: Raman Referenzspektrum 3 (vermutlich Mo₁₈O₅₂).
- Fig. 5:: Raman Referenzspektrum 4 (substöchiometrisches Molybdänoxid mit unbekannter Zusammensetzung, aber nicht Mo₅O₁₄, Mo₈O₂₃, oder Mo₉O₂₆).
- Fig. 6:: Raman Referenzspektrum 5 (MoO₃).
- Fig. 7:: Raman Referenzspektrum 6 (Ta₂O₅).
- Fig. 8:: eine mittels Raman-Mapping erstellte Mikrostruktur eines dritten Ausführungsbeispiels.
- Fig. 9:: eine mittels Raman-Mapping erstellte Mikrostruktur eines vierten Ausführungsbeispiels.
- Fig. 10:: eine mittels Raman-Mapping erstellte Mikrostruktur eines fünften Ausführungsbeispiels.
- Fig. 11:: Reflexionseigenschaften einer unter unterschiedlichen Prozessparametern (Sputterleistung, Prozessgasdruck) abgeschiedenen Molybdän-Tantaloxidschicht.

### Ausführungsbeispiele:

### Beispiel 1

MoO₃-Pulver (Molymet) mit einer mittleren Korngröße von 4,4 µm wird bei 550°C in einer H₂-Atmosphäre (Taupunkt *τ*(H₂) = 10°C) für 17 min. in einem Ofen reduziert. Das erhaltene Mo-Oxid Pulver besitzt einen Sauerstoffgehalt von 73,1 At.%. Es wird in eine Graphitform mit den Abmessungen 260 x 240 mm und einer Höhe von 50 mm gegeben und in einer Heißpresse unter Vakuum bei einem Pressdruck von 45 MPa, einer Temperatur von 750°C und einer Haltezeit von 120 min. verdichtet. Das kompaktierte Bauteil zeigt eine relative Dichte (Porenbestimmung am metallographischen Schliff) von 96% und weist eine MoO₂-Phase mit einem Anteil von 10 Vol.%, eine MoO₃-Phase mit einem Anteil von 7 Vol.% und einen substöchiometrischen Molybdänoxid-Phasenanteil von 83 Vol.% auf. Der substöchiometrische Molybdänoxid-Phasenanteil wird dabei überwiegend von Mo₄O₁₁ gebildet. Die Bestimmung der Phasenzusammensetzung bei diesem und den nachfolgenden Beispielen erfolgt mittels Raman-Mapping und ist im Anschluss an die Beispiele im Detail erläutert.

### Beispiel 2

36,2 Mol% MoO₂-Pulver (Plansee) und 63,8 Mol% MoO₃-Pulver (Molymet) werden in einer Kugelmühle, die mit Zirkonoxid-Mischkugeln (Durchmesser 10 mm) bestückt ist, für 30 min. gemischt und homogenisiert. Die erhaltene Pulvermischung mit einem Sauerstoffgehalt von 72,5 At.% wird in eine Graphitform mit einem Durchmesser von 70 mm und einer Höhe von 50 mm gegeben und in einer Spark-Plasma Sinteranlage (SPS) unter Vakuum bei einem Pressdruck von 40 MPa, einer Temperatur von 775°C und einer Haltezeit von 120 min. verdichtet. Das kompaktierte Bauteil weist eine relative Dichte von 98% auf. Es besteht aus einer MoO₂-Phase mit einem Anteil von 2,7 Vol.% und einen substöchiometrischen Molybdänoxid-Phasenanteil von insgesamt 97,3 Vol.%. Eine MoO₃-Phase konnte nicht nachgewiesen werden. Der substöchiometrische Molybdänoxid-Phasenanteil wird dabei zu 53 Vol.% durch Mo₄O₁₁ gebildet.

### Beispiel 3

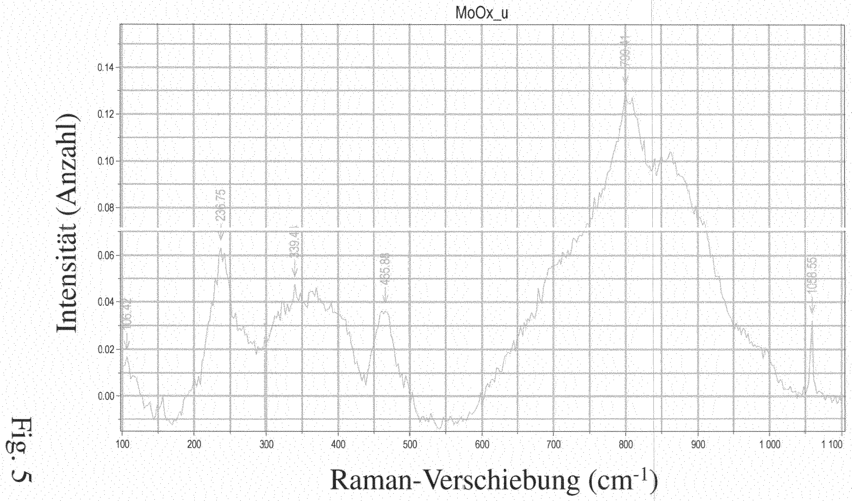

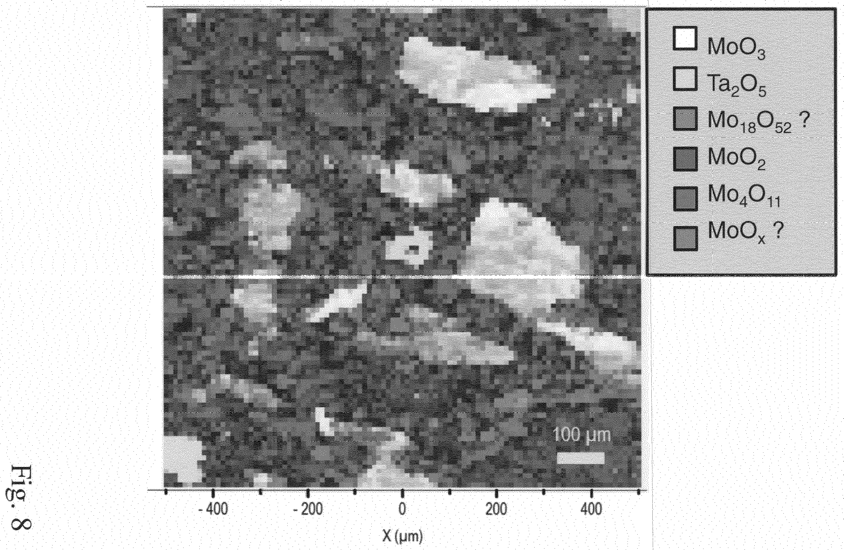

Aus MoO₂-Pulver (Plansee SE) wird in einem Sieb (Maschenweite 32 µm) der Anteil an groben Partikeln und Agglomeraten abgesiebt. 24 Mol.% des erhaltenen MoO₂-Pulvers werden mit 70 Mol.% MoO₃-Pulver (Molymet) und 6 Mol.% Tantalpulver in einem Pflugscharmischer (Lödige) für 20 min. gemischt, so dass sich eine homogene Verteilung zwischen den Pulverkomponenten ergibt. Die erhaltende Pulvermischung wird in eine Graphitform mit den Abmessungen 260 x 240 mm und einer Höhe von 50 mm gegeben und in einer Heißpresse unter Vakuum bei einem Pressdruck von 40 MPa, einer Temperatur von 750°C und einer Haltezeit von 60 min. verdichtet. Das kompaktierte Bauteil weist eine relative Dichte von 95,6% auf. Das erhaltene Targetmaterial weist eine MoO₂-Phase mit einem Anteil von 10,3 Vol.%, eine MoO₃-Phase mit einem Anteil von 19,2 Vol.%, substöchiometrische Molybdänoxide mit einem Gesamtanteil von 68,4 Vol.% und eine Ta₂O₅-Phase mit einem Anteil von 2,1 Vol.% auf. Der überwiegende Anteil der substöchiometrischen Molybdänoxide ist Mo₄O₁₁ mit einem Anteil von 49,4 Vol.%. Die weiteren substöchiometrischen Molybdänoxide sind (vermutlich) Mo₁₈O₅₂ und ein noch nicht bekanntes substöchiometrisches Molybdänoxid mit unbekannter Zusammensetzung. Das Raman-Spektrum dieses substöchiometrischen Molybdänoxids ist in Fig. 5 abgebildet ist. In Fig. 8 ist die mittels Raman-Mapping ermittelte Mikrostruktur des Targetmaterials dargestellt. In der Mikrostruktur sind Bereiche mit MoO₂-Phase, Bereiche mit MoO₃-Phase und Bereiche mit Ta₂O₅-Phase erkennbar; diese verschiedenen Phasen sind inselartig in ein zusammenhängendes Netzwerk, das durch die substöchiometrischen Molybdänoxide Mo₄O₁₁, Mo₁₈O₅₂ und dem substöchiometrischen Molybdänoxid mit unbekannter Zusammensetzung gebildet wird, eingebettet.

### Beispiel 4:

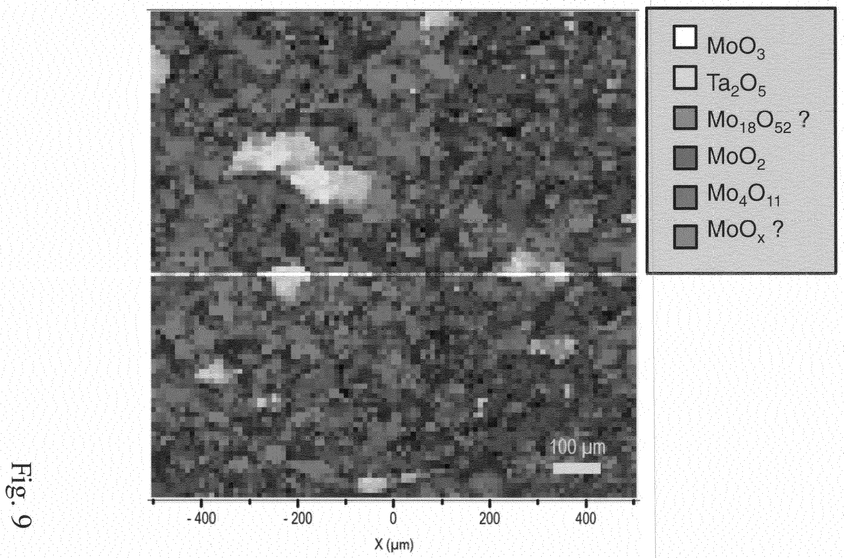

Beispiel 4 unterscheidet sich von Beispiel 3 durch eine Variation der Heißpressparameter, die Pulveransatzfertigung erfolgt wie in Beispiel 3. Die Pulvermischung wird in eine Graphitform mit den Abmessungen 260 x 240 mm und einer Höhe von 50 mm gegeben und in einer Heißpresse unter Vakuum bei einem Pressdruck von 40 MPa, einer Temperatur von 750°C und einer Haltezeit von 240 min. verdichtet. Das kompaktierte Bauteil weist eine relative Dichte von 97% auf. Das erhaltene Targetmaterial weist eine MoO₂-Phase mit einem Anteil von 8,1 Vol.%, eine MoO₃-Phase mit einem Anteil von 5,5 Vol.%, substöchiometrische Molybdänoxide mit einem Anteil von insgesamt 85 Vol.% und eine Ta₂O₅-Phase mit einem Anteil von 1,4 Vol.% auf. Der überwiegende Anteil der substöchiometrischen Molybdänoxide ist Mo₄O₁₁ mit einem Anteil von 59,1 Vol.%. Fig. 9 zeigt die mittels Raman-Mapping erstellte Mikrostruktur des Targetmaterials.

### Beispiel 5:

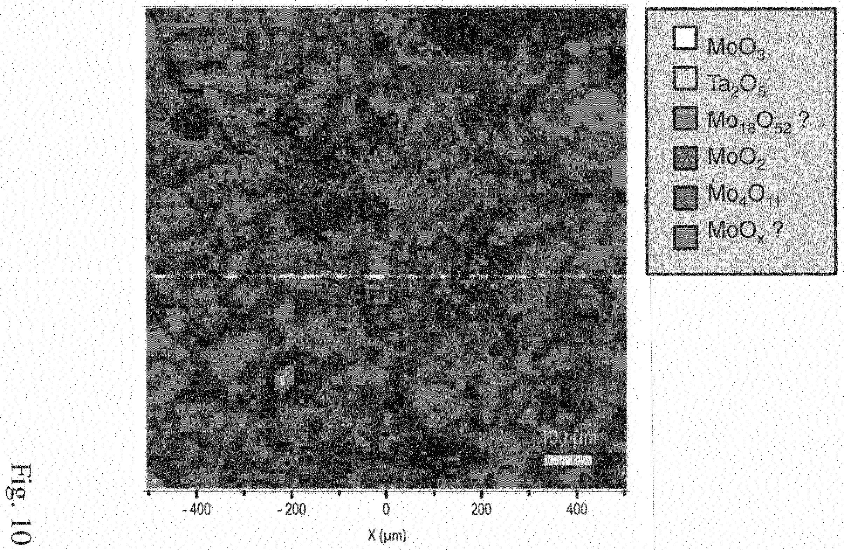

Beispiel 5 unterscheidet sich von Beispiel 3 und 4 durch eine Variation der Heißpressparameter, die Pulveransatzfertigung erfolgt wie in Beispiel 3. Die Pulvermischung wird in eine Graphitform mit den Abmessungen 260 x 240 mm und einer Höhe von 50 mm gegeben und in einer Heißpresse unter Vakuum bei einem Pressdruck von 40 MPa, einer Temperatur von 790°C und einer Haltezeit von 120 min. verdichtet. Das kompaktierte Bauteil weist eine relative Dichte von 99,7% auf. Das erhaltene Targetmaterial weist eine MoO₂-Phase mit einem Anteil von 5,7 Vol.%, substöchiometrische Molybdänoxide mit einem Anteil von 91,9 Vol.% und Ta₂O₅-Phase mit einem Anteil von 2,4 Vol.% auf. Eine MoO₃-Phase ist nicht nachweisbar. Unter den substöchiometrischen Molybdänoxiden haben Mo₄O₁₁ mit einem Anteil von 47,2 Vol.% und das substöchiometrische Molybdänoxid mit unbekannter Zusammensetzung mit einem Anteil von 31,4 Vol.% den größten Anteil. Das Raman-Spektrum des noch unbekannten substöchiometrischen Molybdänoxids ist in Fig. 5 abgebildet. Die mittels Raman-Mapping erstellte Mikrostruktur des Targetmaterials ist in Fig. 10 dargestellt.

Zur Bestimmung der Volumenanteile der unterschiedlichen Phasen und der Dichte des Targetmaterials wurde mittels Trockenpräparation ein metallographischer Schliff aus einem repräsentativen Probenteil hergestellt, indem eine Probe mit einer Fläche von ca. 10-15 x 10-15 mm² im Trockenschnittverfahren (Diamantdrahtsäge, Bandsäge, etc.) zugeschnitten, mittels Druckluft gereinigt, anschließend warm und leitend (C-dotiert) in Phenolharz eingebettet, geschliffen und poliert wurde. Da zumindest der MoO₃-Phasenanteil wasserlöslich ist, ist eine Trockenpräparation wichtig. Der so erhaltene Schliff wurde anschließend lichtmikroskopisch analysiert.

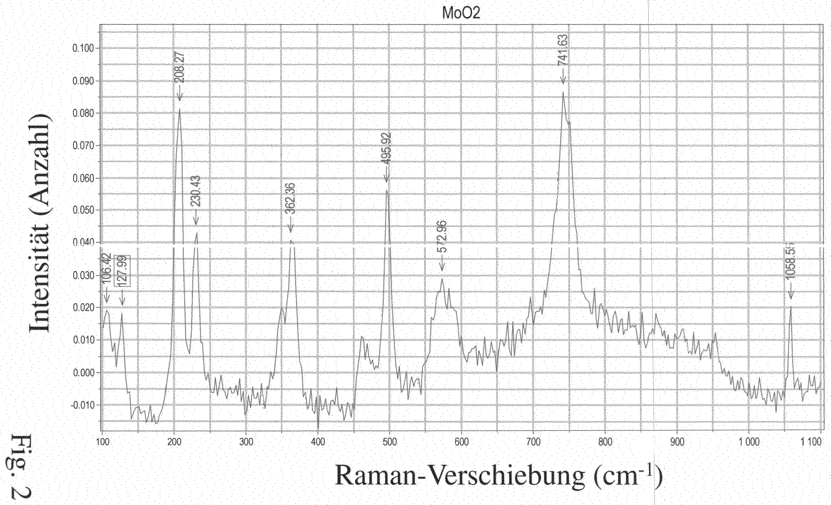

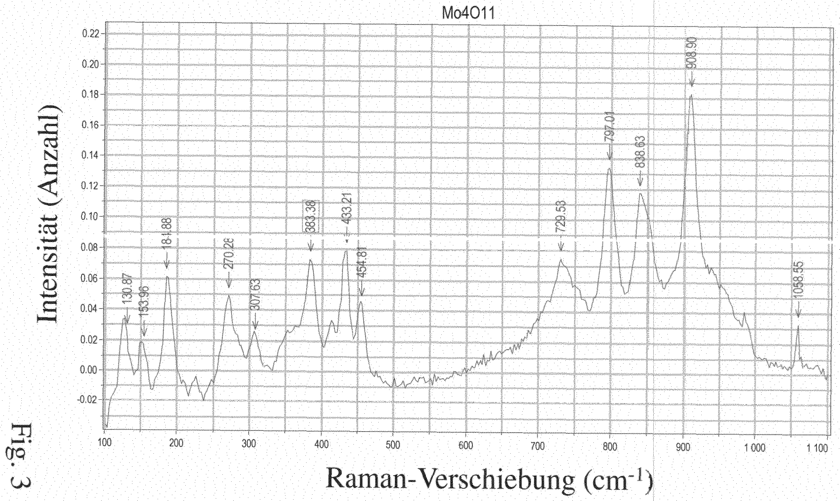

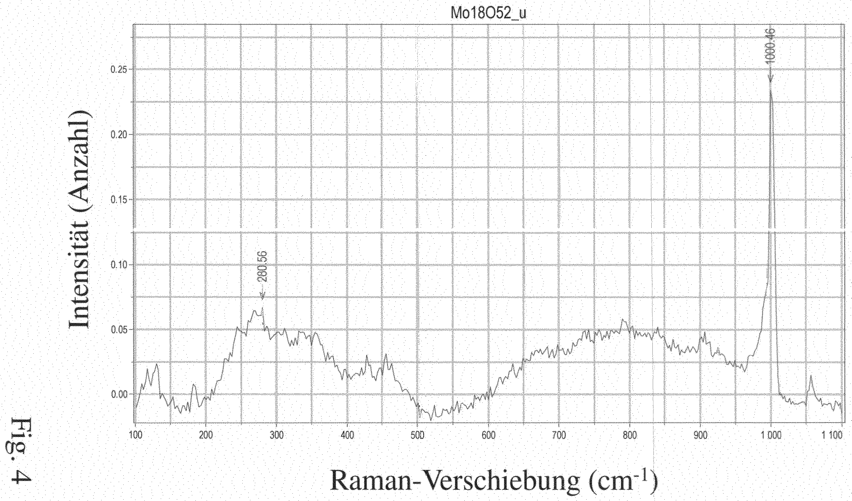

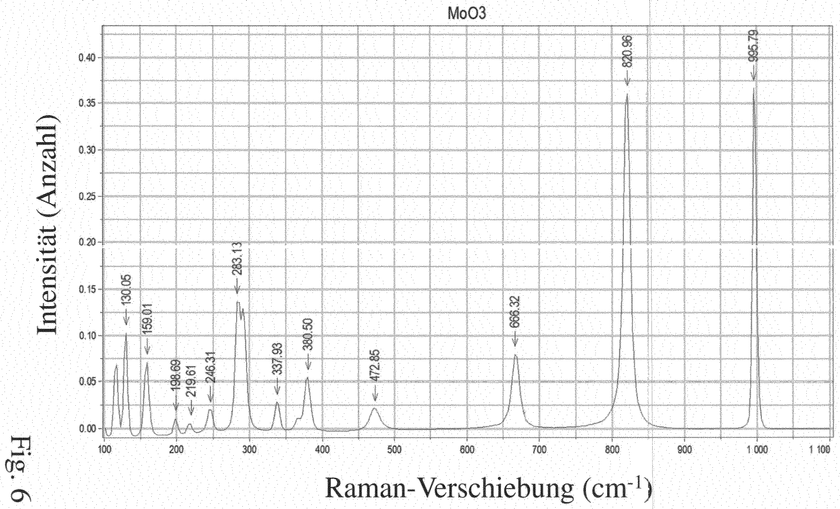

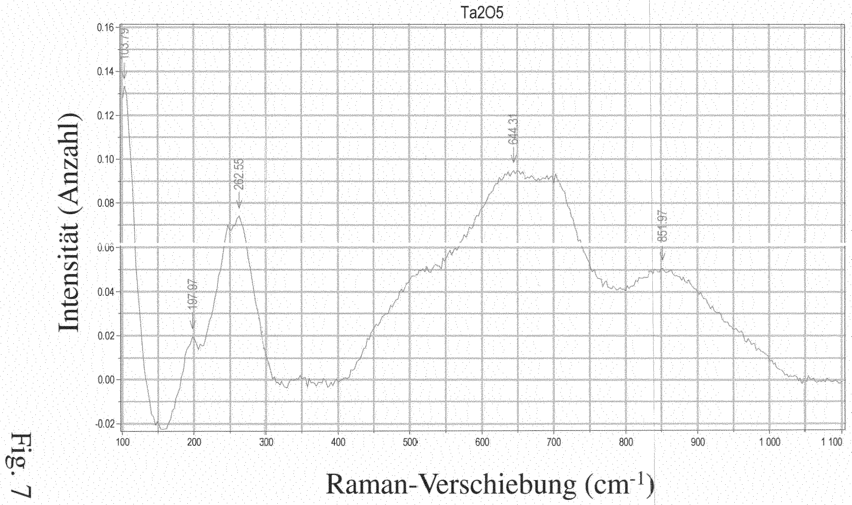

Zur ortsaufgelösten Bestimmung der Molybdänoxid-Phasen wurde ein Raman-Mikroskop (Horiba LabRAM HR800) verwendet, bei dem ein konfokales Lichtmikroskop (Olympus BX41) mit einem Ramanspektrometer gekoppelt ist. Die zu analysierende Oberfläche wurde dabei auf einer Fläche von 1 x 1 mm² mit Hilfe eines fokussierten Laserstrahls (He-Ne-Laser, Wellenlänge λ = 632,81 nm, 15 mW Gesamtleistung) Punkt für Punkt mit einer Schrittweite von 10 µm abgerastert (die zu untersuchende Probeoberfläche wurde auf einen motorisierten XYZ-Tisch fixiert und dieser bewegt). Für jeden einzelnen der 100 x 100 Messpunkte wurde ein vollständiges Raman- Spektrum erstellt ("Raman-Mapping"). Raman Spektren werden aus der rückgestreuten Strahlung gewonnen, die über ein optisches Gitter (300 Linien/mm; spektrale Auflösung: 2,6 cm⁻¹) wellendispersiv aufgespalten, und mittels eines CCD-Detektors (1024 × 256 pixel multichannel CCD; Spektralumfang: 200-1050 nm) aufgenommen werden. Bei einem Mikroskop-Objektiv mit 10-facher Vergrößerung und numerischer Apertur NA von 0,25, welches zur Fokussierung des Laserstrahls aus dem Raman-Spektrometer dient, ließ sich eine theoretische Messpunkt-Größe von 5,2 µm² erzielen. Die Anregungsenergiedichte (3 mW/µm²) wird gering genug gewählt um Phasenumwandlungen in der Probe zu vermeiden. Die Eindringtiefe der Anregungsstrahlung ist bei Molybdänoxiden auf einige Mikrometer begrenzt (im Falle von reinem MoO₃ hier ca. 4 µm; da jedoch eine Mischung aus unterschiedlichen Phasen analysiert wird, ist eine genaue Angabe der Eindringtiefe nicht möglich). Pro Messpunkt wurde das Ramansignal über 4s Akquisitionszeit zeitlich gemittelt, wobei sich ein ausreichend gutes Signal-zu-Rauschverhältnis ergab. Durch automatisierte Auswertung dieser Raman-Spektren (Auswertesoftware Horiba LabSpec 6) wurde eine zweidimensionale Darstellung der Oberflächenzusammensetzung der Probe erstellt, aus der sich quantitativ die Domänengröße, Flächenanteile, etc. der verschiedenen Phasen ermitteln lassen. Zur genauen Identifizierung einer Molybdänoxidphase werden Referenzspektren an zuvor synthetisierten Referenzproben bzw. Referenzspektren an größeren homogenen Probenbereichen aufgenommen, wobei darauf geachtet wird, dass ein Referenzspektrum genau einer Metalloxid-Phase entspricht. In den Fig. 2 bis 7 sind typisch verwendete Referenzspektren von MoO₂, Mo₄O₁₁, Mo₁₈O₅₂, einem bisher unbekannten substöchiometrischen MoOₓ-Oxid, MoO₃ und Ta₂O₅ dargestellt (in den einzelnen Spektren ist die Intensität (Anzahl) des gestreuten Lichts über der Raman-Verschiebung (cm⁻¹) dargestellt). Die Analyse und Zuordnung der Raman-Spektren erfolgt dabei mit Hilfe des "Multivariante Analysis Modules" der oben genannten Auswertesoftware mittels der CLS-Methode (classical least square fitting). Das Probenspektrum *S* wird dazu als Linearkombination der einzelnen normalisierten Referenzspektren *Rᵢ* dargestellt, wobei *cᵢ* der jeweilige Gewichtungsfaktor und Δ ein Offsetwert ist, S= Σcᵢ Rᵢ + Δ. Jedem Messpunkt wird anschließend eine Farbe zugeordnet, die einer Metalloxid-Phase entspricht, wobei jeweils nur die Phase mit dem höchsten Gewichtungsfaktor *cᵢ* für die Farbzuordnung verwendet wird. Die Größe (des Betrages) des Gewichtungsfaktors *cᵢ* bestimmt die Helligkeit des Messpunkts. Dieses Vorgehen ist insofern gerechtfertigt, da sich in der Regel das Spektrum von einem Messpunkt eindeutig einer einzigen Metalloxid-Phase zuordnen lässt.

Bei dem verwendeten Objektiv wurde von allen 100 x 100 Messpunkten ein Probenspektrum erhalten, auch wenn auf einer Pore gemessen wurde. In diesem Fall stammte das Signal aus einem unter der Pore liegenden, tieferen Bereich. Falls für einzelne Messpunkte kein Ramanspektrum erhalten wird, z.B. aufgrund einer Pore, so kann dieses aus der Bestimmung der Flächenanteile ausgenommen werden, d.h. das von den Poren des Targetmaterials eingenommene Volumen ist vom Gesamtvolumen ausgeklammert. Die Volumenangaben der einzelnen Molybdänoxid-Phasen addieren sich daher alleine ohne das Porenvolumen auf 100%.

Die hier beschriebene Analysenmethode eignet sich insbesondere zur Bestimmung der relativen Phasenanteile von unterschiedlichen Mo-Oxiden. In einer Wiederholungsmessung (eine Probe wurde 3 Mal hintereinander gemessen) wurde ein relativer Messfehler von ±10% (bezogen auf den jeweils ermittelten Phasenanteil) ermittelt. Der relative Messfehler bei der Vol.%-Bestimmung der Dotandenoxide (z.B. Ta₂O₅) beträgt allerdings ±25%. Daher ist es möglich, dass die gemessenen Vol.%-Angaben in den Beispielen leicht von den eingewogenen Mengen an Dotanden-Metall (z.B. Tantal), bzw. Dotanden-Metalloxid(z.B. Ta₂O₅) abweichen.

Die Bestimmung der relativen Dichte erfolgt mittels digitaler Bildanalyse von lichtmikroskopischen Bildaufnahmen des metallographischen Schliffs, bei dem der relative Flächenanteil der Poren ermittelt wird. Dazu erfolgte nach Präparation der Proben eine Bildaufnahme von je drei Hellfeld-Aufnahmen mit einer Größe von 1 x 1mm mit 100-facher Vergrößerung, wobei Zonen offensichtlicher Ausbrüche oder sonstiger Schadensbilder wie Kratzer aufgrund von Trockenpräparation nach Möglichkeit vermieden wurden. Die erhaltenen Bilder wurden mittels der in der IMAGIC-Bilddatenbank implementierten digitalen Bildverarbeitungssoftware ausgewertet. Dazu wurde am Bild abhängig von der Graustufe der Porenanteil (dunkel) anhand eines Histogramms markiert. Die Untergrenze des Intervalls wurde bei 0 (= schwarz) angesetzt. Demgegenüber muss die Obergrenze subjektiv anhand des Graustufen-Intensitätshistogramms eingeschätzt werden (255 = weiß). Der zu messende Bildbereich wurde eingestellt (ROI), um den Maßstabsbalken auszuschließen. Als Ergebnis erhält man den relativen Flächenanteil (in Prozent) und das entsprechend des selektierten Graustufenintervalls eingefärbte Bild (gefärbt bedeutet, dass dieser Pixel in die Messung aufgenommen wurde und demnach als Pore gezählt wurde). Der Wert für die relative Dichte wurde als arithmetisches Mittel aus drei derartigen Porositätsmessungen ermittelt.

### Beispiel 6

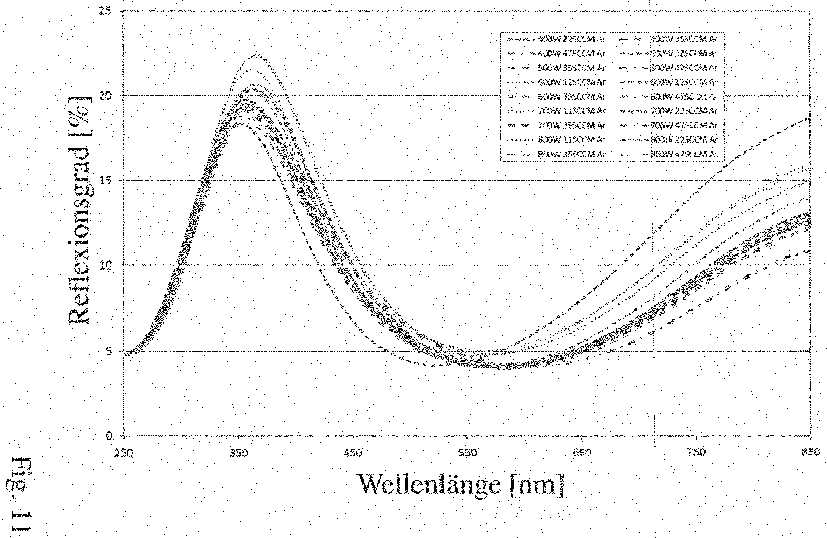

Im Rahmen einer Versuchsserie wurde das nach Beispiel 3 hergestellte Molybdän-Tantal-Oxid Target bei unterschiedlichen Prozessbedingungen nicht-reaktiv gesputtert, um die Reproduzierbarkeit und Prozessstabilität anhand der Schichteigenschaften zu überprüfen. Dabei wurde die Reflektivität der erzeugten Schichten als Kriterium für die Beurteilung verwendet. Zur Bestimmung der Reflektivität wurden Glassubstrate (Corning Eagle XG, 50x50x0,7 mm³) mit Molybdän-Tantaloxid und einer Deckschicht aus 200 nm Al beschichtet. Die Reflektion wurde durch das Glassubstrat hindurch unter Verwendung eines Perkin Elmer Lambda 950 Photospektrometers gemessen. Um eine möglichst geringe Reflektivität zu erhalten, wurde die Schichtdicke des Molybdänoxids in einem ersten Versuch in einem Bereich von 40 bis 60 nm variiert, wobei das beste Ergebnis mit 51 nm Schichtdicke erreicht werden konnte. Diese Schichtdicke wurde daraufhin für alle weiteren Versuche verwendet und konstant gehalten. Ergebnisse aus dieser Versuchsserie sind in Figur 11 dargestellt. Es wurde dabei die Sputterleistung zwischen 400 W und 800 W und der Prozessdruck des Argons zwischen 2,5 x 10⁻³ mbar (11 sccm) und 1,0 x 10⁻² mbar (47 sccm) variiert. Es ist zu erkennen, dass sowohl die Erhöhung der Leistung um einen Faktor 2 von 400 W auf 800 W als auch die Erhöhung des Prozessdrucks um einen Faktor 2 von 5 x 10⁻³ mbar auf 1 x 10⁻² mbar nur einen vernachlässigbaren Einfluss auf die gemessenen Schichteigenschaften haben.

Es wurde somit die hohe Prozessstabilität des Sputterprozesses mit einem Molybdän-Tantaloxid Target bestätigt. Es können reproduzierbare Ergebnisse in einem weiten Prozessfenster erzielt werden, ganz im Gegensatz zum reaktiven Sputterprozess von einem metallischen Target, der höchst instabil ist.

## Patentansprüche

1. Elektrisch leitfähiges, oxidisches Targetmaterial aufweisend einen substöchiometrischen Molybdänoxid-Phasenanteil von zumindest 60 Vol.%, der gebildet wird durch eine oder mehrere substöchiometrische MoO_{3-y}-Phase(n), wobei y jeweils im Bereich von 0,05 bis 0,25 ist, eine MoO₂-Phase mit einem Anteil von 2-20 Vol.%,
optional eine MoO₃-Phase mit einem Anteil von 0-20 Vol.%, wobei die Volumenanteile der Phasen mittels Raman-Spektrometrie bestimmt werden.

2. Targetmaterial nach Anspruch 1, **dadurch gekennzeichnet, dass** der Anteil der MoO₃-Phase ≤ 1 Vol.% ist.

3. Targetmaterial nach Anspruch 1 oder 2, **dadurch gekennzeichnet, dass** der substöchiometrische Molybdänoxid-Phasenanteil zumindest 85 Vol.% ist und dass der Anteil der MoO₂-Phase im Bereich von 2-15 Vol.% liegt.

4. Targetmaterial nach einem der vorangehenden Ansprüche, **dadurch gekennzeichnet, dass** der substöchiometrische Molybdänoxid-Phasenanteil durch mindestens eine der substöchiometrischen Phasen Mo₄O₁₁, Mo₁₇O₄₇, Mo₅O₁₄, Mo₈O₂₃, Mo₉O₂₆ und Mo₁₈O₅₂ gebildet wird.

5. Targetmaterial nach einem der vorangehenden Ansprüche, **dadurch gekennzeichnet, dass** es zu mindestens 45 Vol.% aus der substöchiometrischen Phase Mo₄O₁₁ besteht.

6. Targetmaterial nach einem der vorangehenden Ansprüche, **dadurch gekennzeichnet, dass** das Targetmaterial zusätzlich als Dotand ein metallisch oder oxidisch vorliegendes, von Molybdän verschiedenes Metall zwischen 0,5 Mol% und 20 Mol% enthält.

7. Targetmaterial nach Anspruch 6, **dadurch gekennzeichnet, dass** der Dotand ein Metall aus der Gruppe Tantal, Niob, Titan, Chrom, Zirkon, Vanadium, Hafnium, Wolfram ist.

8. Targetmaterial nach Anspruch 6 oder 7, **dadurch gekennzeichnet, dass** der Dotand Tantal ist und zumindest anteilig als eigene Phase aus Tantaloxid vorliegt.

9. Targetmaterial nach Anspruch 6 oder 7, **dadurch gekennzeichnet, dass** der Dotand Niob ist und zumindest anteilig als eigene Phase aus Nioboxid vorliegt.

10. Targetmaterial nach einem der vorherigen Ansprüche, **dadurch gekennzeichnet, dass** der substöchiometrische Molybdänoxid-Phasenanteil als Matrix ausgebildet ist, in welche die weiteren Phasen eingebettet sind.

11. Targetmaterial nach einem der vorherigen Ansprüche, **dadurch gekennzeichnet, dass** die relative Dichte des Targetmaterials > 98% ist.

12. Targetmaterial nach einem der vorherigen Ansprüche, **dadurch gekennzeichnet, dass** der Sauerstoffgehalt des Targetmaterials zwischen 71,4 und 74,5 At.% beträgt.

13. Verfahren zur Herstellung eines Targetmaterials gemäß einem der vorangehenden Ansprüche, wobei das Verfahren folgende Schritte aufweist:
o Bereitstellen eines molybdänoxidhaltigen Pulvers bzw. einer molybdänoxidhaltigen Pulvermischung mit einem für das herzustellende Targetmaterial angepassten Sauerstoffgehalt und einer mittleren Partikelgröße mit einem Durchmesser kleiner als 150 µm gemessen mit Malvern Laserbeugung
o Einfüllen der Pulvermischung in eine Form
o Verdichten der Pulvermischung durch Druck und/oder Temperatur.

14. Verfahren nach Anspruch 13, **dadurch gekennzeichnet, dass** das Verdichten mittels Heißpressen, Heiß-isostatisch-Pressen, Spark Plasma Sintern oder Pressen-Sintern erfolgt.

## Claims

1. Electrically conductive, oxidic target material comprising
a proportion of substoichiometric molybdenum oxide phases of at least 60% by volume, which is formed by one or more substoichiometric MoO_{3-y} phase(s), where y is in each case in the range from 0.05 to 0.25,
an MoO₂ phase in a proportion of 2-20% by volume,
optionally an MoO₃ phase in a proportion of 0-20% by volume, wherein the volume fraction of the phases is determined by Raman spectroscopy.

2. Target material according to Claim 1, **characterized in that** the proportion of the MoO₃ phase is ≤ 1% by volume.

3. Target material according to Claim 1 or 2, **characterized in that** the proportion of substoichiometric molybdenum oxide phases is at least 85% by volume and **in that** the proportion of the MoO₂ phase is in the range 2-15% by volume.

4. Target material according to any of the preceding claims, **characterized in that** the substoichiometric molybdenum oxide phase proportion is formed by at least one of the substoichiometric phases Mo₄O₁₁, Mo₁₇O₄₇, Mo₅O₁₄, Mo₈O₂₃, Mo₉O₂₆ and Mo₁₈O₅₂.

5. Target material according to any of the preceding claims, **characterized in that** it consists to an extent of at least 45% by volume of the substoichiometric phase Mo₄O₁₁.

6. Target material according to any of the preceding claims, **characterized in that** the target material additionally contains a metal other than molybdenum present in metallic or oxidic form as dopant in an amount of from 0.5 mol% to 20 mol%.

7. Target material according to Claim 6, **characterized in that** the dopant is a metal from the group consisting of tantalum, niobium, titanium, chromium, zirconium, vanadium, hafnium, tungsten.

8. Target material according to Claim 6 or 7, **characterized in that** the dopant is tantalum and is at least partly present as separate phase composed of tantalum oxide.

9. Target material according to Claim 6 or 7, **characterized in that** the dopant is niobium and is at least partly present as separate phase composed of niobium oxide.

10. Target material according to any of the preceding claims, **characterized in that** the substoichiometric molybdenum oxide phase proportion is configured as matrix in which the further phases are embedded.

11. Target material according to any of the preceding claims, **characterized in that** the relative density of the target material is > 98%.

12. Target material according to any of the preceding claims, **characterized in that** the oxygen content of the target material is in the range from 71.4 to 74.5 at.%.

13. Process for producing a target material according to any of the preceding claims, wherein the process comprises the following steps:
o provision of a molybdenum oxide-containing powder or a molybdenum oxide-containing powder mixture having an oxygen content matched to the target material to be produced and an average particle size with a diameter of less than 150 µm determined by Malvern laser diffraction
o introduction of the powder mixture into a mould
o densification of the powder mixture by means of pressure and/or heat.

14. Process according to Claim 13, **characterized in that** densification is carried out by means of hot pressing, hot isostatic pressing, spark plasma sintering or pressing-sintering.

## Revendications

1. Matériau cible oxyde, électriquement conducteur, présentant une proportion de phase d'oxyde de molybdène sous-stoechiométrique d'au moins 60% en volume, qui est formée par une ou plusieurs phase(s) de MoO_{3-y} sous-stoechiométrique, y étant situé à chaque fois dans la plage de 0,05 à 0,25, une phase de MoO₂ représentant une proportion de 2-20% en volume, éventuellement une phase de MoO₃ représentant une proportion de 0-20% en volume, les proportions en volume des phases étant déterminées au moyen de la spectrométrie Raman.

2. Matériau cible selon la revendication 1, **caractérisé en ce que** la proportion de phase de MoO₃ est ≤ 1% en volume.

3. Matériau cible selon la revendication 1 ou 2, **caractérisé en ce que** la proportion de phase d'oxyde de molybdène sous-stoechiométrique représente au moins 85% en volume et **en ce que** la proportion de phase de MoO₂ se situe dans la plage de 2-15% en volume.

4. Matériau cible selon l'une des revendications précédentes, **caractérisé en ce que** la proportion de phase d'oxyde de molybdène sous-stoechiométrique est formée par au moins l'une des phases sous-stoechiométriques Mo₄O₁₁, Mo₁₇O₄₇, Mo₅O₁₄, Mo₈O₂₃, Mo₉O₂₆ et Mo₁₈O₅₂.

5. Matériau cible selon l'une des revendications précédentes, **caractérisé en ce qu'**il est constitué, à raison d'au moins 45% en volume, de la phase sous-stoechiométrique Mo₄O₁₁.

6. Matériau cible selon l'une des revendications précédentes, **caractérisé en ce que** le matériau cible contient en plus, en tant que dopant, un métal se trouvant sous forme métallique ou d'oxyde, différent du molybdène, entre 0,5% en mole et 20% en mole.

7. Matériau cible selon la revendication 6, **caractérisé en ce que** le dopant est un métal du groupe tantale, niobium, titane, chrome, zirconium, vanadium, hafnium, tungstène.

8. Matériau cible selon la revendication 6 ou 7, **caractérisé en ce que** le dopant est du tantale et se trouve au moins en partie sous forme de phase propre en oxyde de tantale.

9. Matériau cible selon la revendication 6 ou 7, **caractérisé en ce que** le dopant est du niobium et se trouve au moins en partie sous forme de phase propre en oxyde de niobium.

10. Matériau cible selon l'une des revendications précédentes, **caractérisé en ce que** la proportion de phase d'oxyde de molybdène sous-stoechiométrique est réalisée sous forme de matrice, dans laquelle les autres phases sont incorporées.

11. Matériau cible selon l'une des revendications précédentes, **caractérisé en ce que** la densité relative du matériau cible est > 98%.

12. Matériau cible selon l'une des revendications précédentes, **caractérisé en ce que** la teneur en oxygène du matériau cible est située entre 71,4 et 74, 5% en atome.

13. Procédé pour la fabrication d'un matériau cible selon l'une des revendications précédentes, le procédé présentant les étapes suivantes :
O mise à disposition d'une poudre contenant de l'oxyde de molybdène ou d'un mélange de poudres contenant de l'oxyde de molybdène présentant une teneur en oxygène adaptée au matériau cible à fabriquer et une grosseur moyenne de particule d'un diamètre inférieur à 150 µm, mesuré par diffraction laser au Malvern
O introduction du mélange de poudres dans un moule
O compression du mélange de poudres par pression et/ou température.

14. Procédé selon la revendication 13, **caractérisé en ce que** la compression est réalisée au moyen d'un pressage à chaud, d'un pressage isostatique à chaud, d'un frittage par plasma à étincelle ou d'un pressage-frittage.
